# EUROPEAN PATENT APPLICATION

(11) **EP 2 397 746 A2**
(43) Date of publication of application: **21.12.2011**
(21) Application number: 11169878.3
(22) Date of filing: 14.06.2011
(51) Int. Cl.: F21K 99/00, H05K 1/02, H01L 25/075

(54) **Light-emitting module and illumination device**

(30) Priority: 15.06.2010 JP 2010136509
(71) Applicant: Toshiba Lighting & Technology Corporation, Yokosuka-shi Kanagawa 237-8510 (JP)
(72) Inventor: Sanpei, Tomohiro, Kanagawa, 237-8510 (JP)
(74) Representative: Sander Jakobsson, Sofia Ellinor

(57) **Abstract**

According to one embodiment, a light-emitting module comprises a module substrate (25), a light-reflecting layer (28), a plurality of light-emitting elements (37), and a sealing material (46). The module substrate (25) includes an insulating layer (27) formed of at least one of a glycidyl ester-type, linear aliphatic epoxide-type, and alicyclic epoxide-type resin. The light-reflecting layer (28) is superposed on the insulating layer (27), and includes a silver light-reflecting surface (32). The light-emitting elements (37) are mounted on the module substrate (25). The sealing material (46) has light transmittance, and superposed on the insulating layer (27) to cover the light-reflecting layer (28) and the light-emitting elements (37).

## Description

### FIELD

Embodiments described herein relate generally to a light-emitting module in which a plurality of light-emitting elements are mounted on a light-reflecting surface formed of silver and the like, and an illumination device provided with the light-emitting module.

### BACKGROUND

Light-emitting modules of the chip-on-a-board (COB) type include a module substrate, and a plurality of light-emitting diodes which are mounted on the module substrate. The module substrate is formed of, for example, glycidyl ether-type epoxy resin.

In prior art, to effectively extract light emitted from light-emitting diodes, it is attempted to superpose a light-reflecting layer formed of silver on the module substrate. The light-reflecting layer is used for reflecting light emitted from the light-emitting diodes toward the module substrate in an original direction in which the light should be extracted, and the light-reflecting layer is at least provided in a position which corresponds to the light-emitting diodes.

The light-reflecting layer which reflects light emitted from the light-emitting diodes is required to maintain good light reflection efficiency for a long period. However, in light-emitting modules of prior art, the surface of the light-reflecting layer becomes discolored, blackening with the passage of the lighting time, which causes a decrease in luminous flux.

### BRIEF DESCRIPTION OF THE DRAWINGS

FIG. 1 is an exemplary perspective view of an LED lamp according to an embodiment;
FIG. 2 is an exemplary cross-sectional view of the LED lamp according to the embodiment;
FIG. 3 is an exemplary plan view of a light-emitting module according to the embodiment;
FIG. 4 is an exemplary cross-sectional view of the light-emitting module according to the embodiment; and
FIG. 5 is an exemplary characteristic diagram illustrating relation between the lighting time and the lumen maintenance factor of the light-emitting module according to the embodiment.

### DETAILED DESCRIPTION

In general according to one embodiment, a light-emitting module comprises a module substrate, a light-reflecting layer, a plurality of light-emitting elements, and a sealing material. The module substrate has an insulating layer formed of at least one of a glycidyl ester-type, linear aliphatic epoxide-type, and alicyclic epoxide-type resin. The light-reflecting layer is superposed on the insulating layer, and has a silver light-reflecting surface which has light reflectance higher than that of the insulating layer. The light-emitting elements are mounted on the module substrate. The sealing material has light transmittance, and is superposed on the insulating layer to cover the light-reflecting layer and the light-emitting elements.

In a light-emitting module of a first aspect, light-emitting elements indicate light-emitting diodes formed of a bare chip. Each of light-emitting diodes of this type includes a pair of electrodes, and bonded onto the light-reflecting surface by using a die bond material having light transmittance.

The light-emitting elements are arranged at intervals between them, and form light-emitting element columns. Each light-emitting element column is preferably disposed in a straight line, but may have at least one bent portion which is bent at right angles between one end and the other end of the light-emitting element column. Adjacent light-emitting elements are electrically connected through a plurality of bonding wires. The bonding wires may be any metal thin wires, preferably copper (Cu) thin wires.

The light-reflecting surface of the light-reflecting layer is used for reflecting light emitted from the light-emitting elements toward the module substrate, and effectively extracting the light from the light-emitting module. The light-reflecting surface should have a size on which the light-emitting elements can be mounted. The light-reflecting layer may be formed of a single layer or a plurality of layers. It suffices that at least the surface of the light-reflecting layer is formed of a silver layer. As the sealing material, it is desirable to use, for example, a transparent silicone resin. The sealing material is not limited to silicone resin, but other light-transmitting resin materials can be used as the sealing material.

In the light-emitting module of the first aspect, to obtain white light by using light-emitting elements which emit blue light, yellow fluorescent material which is excited by blue light and emits yellow light should be mixed into the sealing material. In the same manner, to obtain white light by using light-emitting elements which emit ultraviolet rays, the sealing material should include a red fluorescent material which is excited by ultraviolet rays and emits red light, a green fluorescent material which is excited by ultraviolet rays and emits green light, and a blue fluorescent material which is excited by ultraviolet rays and emits blue light.

In addition, a plurality of light-emitting element assemblies, each of which is formed of three types of light-emitting elements that emit red, green, and blue light beams, may be mounted onto the light-reflecting surface. According to this structure, light beams emitted from the three light-emitting elements are mixed together, and white light is emitted from each light-emitting element assembly. Therefore, it is unnecessary to mix fluorescent materials into the sealing material.

In the light-emitting module of the first aspect, the insulating layer of the module substrate is formed of glycidyl ester-type, linear aliphatic epoxide-type, or alicyclic epoxide-type epoxy resin. In epoxy resin of this type, a resin component which serves as framework of the epoxy resin is decomposed into gas by light and heat, when the resin receives light and heat emitted by the light-emitting elements.

The decomposed gas of the epoxy resin is more resistant to light and heat than glycidyl ether-type or glycidyl amine-type epoxy resin, and is difficult to change in quality. Therefore, even when the decomposed gas adheres to the light-reflecting surface, there is low possibility that the decomposed gas is carbonized on the light-reflecting surface. In addition, even when the decomposed gas is carbonized, the quantity of the carbonized material is small. Therefore, it is possible to suppress formation of blackish stains on the light-reflecting surface.

The insulating layer of the module substrate may be epoxy resin of any one of glycidyl ester-type, linear aliphatic epoxide-type and/or alicyclic epoxide-type, or epoxy resin formed by combining them.

According to a light-emitting module of a second aspect, epoxy resin which forms the insulating layer is made by using acid anhydride as a hardener. Acid anhydride is classified into aliphatics, alicyclics, aromatics, and halogens. Typical aliphatic hardeners are dodecenyl succinic anhydride (DDSA), and polyazelaic polyanhydride (PAPA). Typical alicyclic hardeners are hexahydrophthalic anhydride (HHPA), methyltetrahydrophthalic anhydride (MTHPA), and methylnadic anhydride (MNA). Typical aromatic hardeners are trimet anhydride (TMA), pyromellitic dianhydride (PDMA), and benzophenonetetracarboxilic dianhydride (BTDA). Typical halogen hardeners are tetrabromophthalic anhydride (TBPA), and chlorendic anhydride (HET).

Epoxy resin can obtain various characteristics by use in combination with a hardener according to the use. For example, as epoxy resin for print wiring boards, used are epoxy phenol-type epoxy resin using phenols as a hardener, epoxy amine-type epoxy resin using amines as a hardener, and epoxy acid anhydride-type epoxy resin using acid anhydride as a hardener. In the present circumstances, epoxy phenol-type epoxy resin is mainly used as epoxy resin for printed wiring boards.

The inventor(s) investigated the phenomenon that various epoxy resins are decomposed by light emitted from blue light-emitting diodes and the phenomenon that the silver light-reflecting surface blackens, and found that hardeners of a certain type are decomposed into gas by light from blue light-emitting diodes.

Specifically, in epoxy-phenol-type epoxy resin and epoxy amine-type epoxy resin, the inventor(s) found that a decomposed material of the phenol-type resin and amine-type resin used as the hardener thereof causes blackening of the silver light-reflecting surface. In addition, the inventor(s) found that epoxy acid anhydride-type epoxy resin does not cause blackening of the silver light-reflecting surface even when the acid anhydride being a hardener is decomposed.

Therefore, in epoxy acid anhydride-type epoxy resin, although the resin component of the hardener is decomposed into gas by light emitted from light-emitting elements, a decomposed material does not react with the silver light-reflecting surface, or reacts with a neglectable small quantity. Therefore, it is possible to prevent the light-reflecting surface from blackening.

According to a light-emitting module of a third aspect, the module substrate includes a metal base. The base includes a rough surface on which an insulating layer is superposed. The rough surface of the base has a plurality of minute depressions and projections.

According to the above structure, most of the heat produced by light-emitting elements when the light-emitting elements emit light is conducted from the insulating layer to the base and diffused into the base. Therefore, the heat of the light-emitting elements can be radiated from the base to the outside of the module substrate, and heat-radiation property of the light-emitting elements is improved. In addition, since the heat of the light-emitting elements is radiated from the base, it is possible to ease heat influence of the light-emitting elements on the insulating layer. Therefore, the insulating layer is not easily deteriorated, and the quantity itself of a gaseous decomposed material produced by the insulating layer is reduced. Thus, it is possible to suppress change in color of the light-reflecting surface due to the decomposed material.

In addition, since the base includes a rough surface, the insulating layer is engaged with minute depressions and projections existing on the rough surface of the base. Therefore, it is possible to secure the bonding strength between the insulating layer and the base at, for example, 1.0 kgf/mm².

According to a light-emitting module of a fourth aspect, the light-reflecting surface includes a metal layer which serves as an underlayer of the light-reflecting surface. The metal layer includes a rough mating surface which is superposed on the insulating layer.

According to the above structure, the insulating layer is engaged with minute depressions and projections existing on the rough mating surface of the metal layer. Therefore, it is possible to secure the bonding strength between the insulating layer and the metal layer at, for example, 1.0 kgf/mm².

An illumination device according to a fifth aspect comprises: a light-emitting module described in any one of the first to fourth aspects; a body which supports the light-emitting module; and a lighting device which is provided in the body and lights the light-emitting module.

In the fifth aspect, the illumination device is an illumination structure such as an LED lamp which has a shape similar to an incandescent lamp and a spotlight, and uses the light-emitting module as a light source.

According to the illumination device, it is possible to prevent the light-reflecting surface of the light-emitting module from blackening, and maintain good light reflection property of the light-reflecting surface. Therefore, it is possible to efficiently extract light emitted from the light-emitting elements for a long period.

Therefore, it is possible to reduce decrease in luminous flux of the illumination device to the minimum.

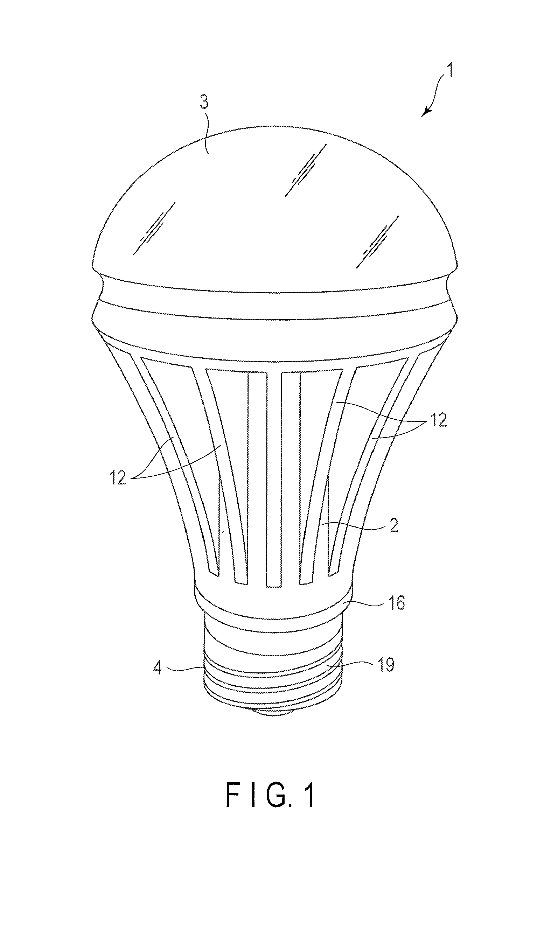

The following is explanation of the embodiment of the illumination device, with reference to FIG. 1 to FIG. 5.

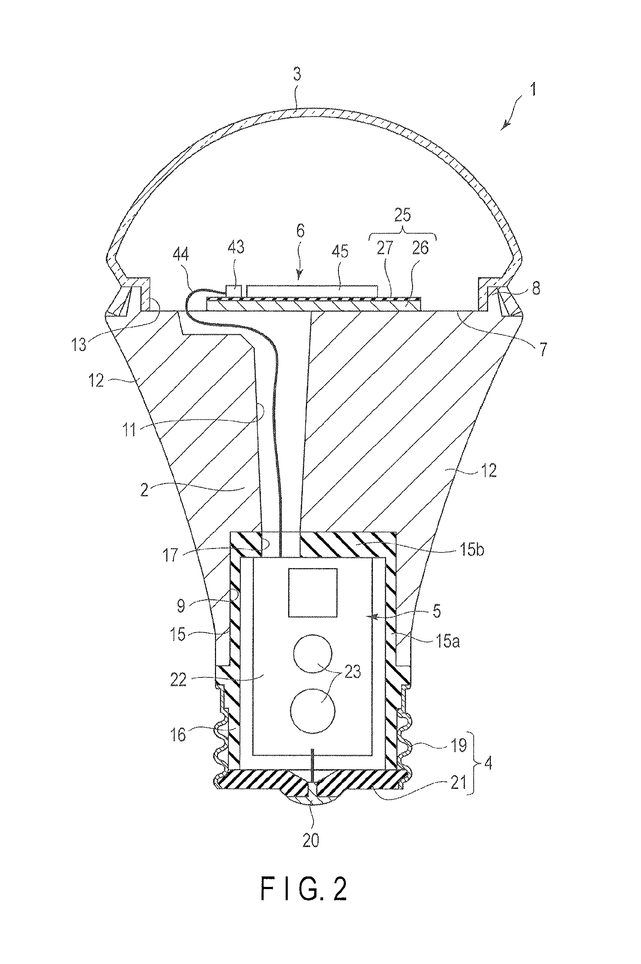

FIG. 1 and FIG. 2 disclose an LED lamp 1 which is an example of the illumination device. LED lamp 1 comprises a lamp body 2, a translucent cover 3, an E-shaped base 4, a lighting device 5, and a chip-on-a-board (COB) light-emitting module 6.

The lamp body 2 is formed of a metal material such as aluminum. The lamp body 2 has a tube shape which has a flat support surface 7 at one end. A ring-shaped support wall 8 is formed as one unitary piece on an outer edge part of the support surface 7. The lamp body 2 includes a concave part 9 at the other end which is opposite to the support surface 7. In addition, a through-hole 11 which extends in an axial direction of the lamp body 2 is formed inside the lamp body 2. One end of the through-hole 11 is opened to the support surface 7. The other end of the through-hole 11 is opened to a bottom of the concave part 9.

The lamp body 2 includes a plurality of thermally radiative fins 12. The thermally radiative fins 12 radially project from an outer peripheral surface of the lamp body 2. In addition, the thermally radiative fins 12 project toward the outside along the radial direction of the lamp body 2, as they go from the other end of the lamp body 2 toward one end.

The translucent cover 3 is formed in an almost hemispherical shape of, for example, a milky-white synthetic resin material. The translucent cover 3 includes an opening edge part 13 which is opened to the support surface 7 of the lamp body 2. The translucent cover 3 is connected to the lamp body 2 by fitting the opening edge part 13 into the support wall 8. The translucent cover 3 covers the support surface 7 of the lamp body 2.

As illustrated in FIG. 2, a base support 15 which has electric non-conductance is attached to the concave part 9 of the lamp body 2. The base support 15 includes a cylindrical circumferential wall 15a, and an end wall 15b which closes one end of the circumferential wall 15a.

The circumferential wall 15a is fitted into the concave part 9, and covers an internal circumferential surface of the concave part 9. The circumferential wall 15a includes a projecting part 16 which projects from the concave part 9 to the outside of the lamp body 2. The end wall 15b covers the bottom of the concave part 9, and includes a through-hole 17 which agrees with the through-hole 11. In addition, an internal space of the base support 15 connects to the support surface 7 of the lamp body 2 through the through-hole 17 and the through-hole 11.

The base 4 is formed of a metal shell 19, and an insulator 21 which includes an eyelet terminal 20. The shell 19 is attached to the projecting part 16 of the base support 15 to cover the projecting part 16 from outside. The insulator 21 abuts on the opening end part of the projecting part 16, and closes the internal space of the base support 15.

The lighting device 5 is contained in the internal space of the base support 15. The lighting device 5 includes a circuit board 22, and a plurality of circuit components 23 such as a transformer, a capacitor, and a transistor, which are mounted on the circuit board 22. The lighting device 5 is electrically connected to the base 4.

The light-emitting module 6 is used as a light source of the LED lamp 1. The light-emitting module 6 is attached to the support surface 7 of the lamp body 2, and covered with the translucent cover 3.

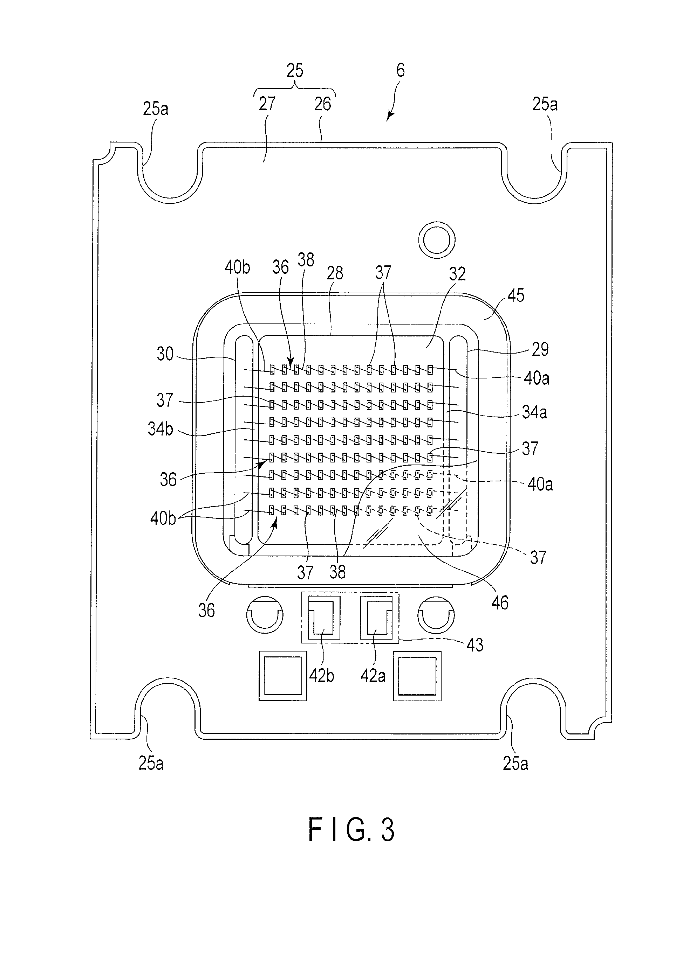

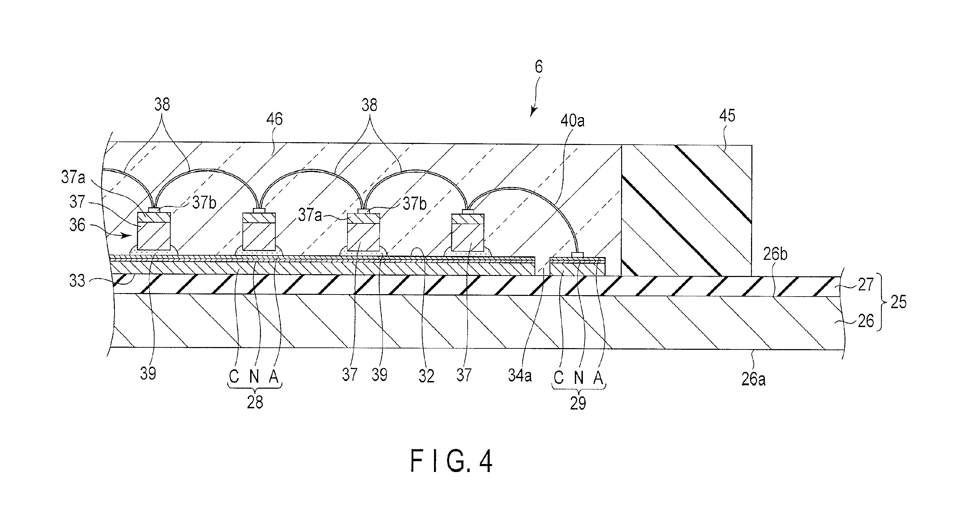

As illustrated in FIG. 3 and FIG. 4, the light-emitting module 6 includes a module substrate 25. The module substrate 25 has a rectangular shape which has four corners. The module substrate 25 includes four cutaway parts 25a. The cutaway parts 25a are located around the respective corners of the module substrate 25.

As illustrated in FIG. 4, the module substrate 25 is formed of a metal base 26 and an insulating layer 27. The base 26 is formed of, for example, aluminum or aluminum alloy. The base 26 includes a first surface 26a and a second surface 26b. The second surface 26b is located reverse to the first surface 26a, and forms a front surface of the base 26. The second surface 26b is a rough surface which includes a plurality of minute depressions and projections.

The insulating layer 27 is superposed on the second surface 26b of the base 26, and covers the whole second surface 26b. The insulating layer 27 is formed of epoxy resin of glycidyl ester-type, linear aliphatic epoxide-type, or alicyclic epoxide-type. When epoxy resin of this type receives light and heat, a resin component which serves as a framework of the epoxy resin gradually deteriorates and produces a gaseous decomposed material.

In the present embodiment, acid anhydride such as hexahydrophathalic anhydride, methyltetrahydrophthalic acid, and pyromellitic dianhydride is used as a hardener which is combined with the epoxy resin. In addition, an inorganic filler such as aluminum oxide is added to the epoxy resin. The addition ratio of filler to the epoxy resin is 30 wt%. In addition, in consideration of reduction of the absolute quantity of the gaseous decomposed material, the thickness of the insulating layer 27 is preferably 130 µm or less, in particular, 80 µm in view of withstand voltage.

In a state where the insulating layer 27 is superposed on the second surface 26b of the base 26, the insulating layer 27 is engaged with the minute depressions and projections existing on the second surface 26b. Therefore, in the present embodiment, the bonding strength between the insulating layer 27 and the base 26 is secured at, for example, 1.0 kgf/mm².

The module substrate 25 is fixed in the center of the support surface 7 of the lamp body 2 by four screws. The screws pass through the cutaway parts 25a of the module substrate 25 and driven into the lamp body 2. Thereby, the first surface 26a of the base 26 is brought into close contact with the support surface 7, and the module substrate 25 is thermally connected to the lamp body 2.

As illustrated in FIG. 3 and FIG. 4, a light-reflecting layer 28, a first power-supply conductor 29, and a second power-supply conductor 30 are superposed on the insulating layer 27 of the module substrate 25. The light-reflecting layer 28 has a rectangular shape which has four sides, and is located in the center of the insulating layer 27. The light-reflecting surface 28 has, for example, a three-layer structure, which is obtained by combining three metal layers. Specifically, the light-reflecting layer 28 is formed by stacking a copper layer C, a nickel layer N, and a silver layer A. The copper layer C is formed by etching a copper foil superposed on the insulating layer 27. The nickel layer N is superposed on the copper layer C. The nickel layer N is formed by subjecting the copper layer C to nonelectrolytic plating. The silver layer A is superposed on the nickel layer N. The silver layer A is formed by subjecting the nickel layer N to nonelectrolytic plating. The silver layer A forms a surface layer of the light-reflecting layer 28.

Therefore, the surface of the light-reflecting layer 28 is a silver light-reflecting surface 32. The light reflectance of the light-reflecting surface 32 is higher than the light reflectance of the insulating layer. The total light reflectance of the light-reflecting surface 32 is, for example, 90.0%.

The copper layer C which serves as an underlayer of the light-reflecting surface 32 has a mating surface 33 which contacts the insulating layer 27. The mating surface 33 is a rough surface which has a number of minute depressions and projections. Therefore, in a state where a copper foil which serves as the base of the copper layer C is superposed on the insulating layer 27, the insulating layer 27 is engaged with the minute depressions and projections existing on the mating surface 33. As a result, in the present embodiment, the bonding strength between the copper layer C and the insulating layer 27 is secured at, for example, 1.0 kgf/mm².

The structure of the light-reflecting layer 28 is not limited to the three-layer structure. For example, the light-reflecting layer 28 may be formed of a single silver layer, or may have a two-layer structure in which a silver layer is superposed on a copper layer serving as an underlayer.

As illustrated in FIG. 3, each of the first and second power-supply conductors 29 and 30 has an elongated rectangular shape which extends along a side of the light-reflecting layer 28. The first and second power-supply conductors 29 and 30 have the same size. Each of the first and second power-supply conductors 29 and 30 has a three-layer structure which includes a copper layer C, a nickel layer N, and a silver layer A, in the same manner as the light-reflecting layer 28. A surface layer of each of the first and second power-supply conductors 29 and 30 is formed of silver.

In addition, the first and second power-supply conductors 29 and 30 are arranged in parallel and apart from each other, to hold the light-reflecting layer 28 therebetween. A slit-shaped space 34a is provided between the light-reflecting layer 28 and the first power-supply conductor 29. The space 34a electrically insulates the light-reflecting layer 28 from the first power-supply conductor 29. In the same manner, a slit-shaped space 34b is provided between the light-reflecting layer 28 and the second power-supply conductor 30. The space 34b electrically insulates the light-reflecting layer 28 from the second power-supply conductor 30. The spaces 34a and 34b are located on the insulating layer 27. Therefore, part of the insulating layer 27 is exposed through the spaces 34a and 34b.

A plurality of light-emitting diode columns 36 are mounted on the light-reflecting surface 32 of the light-reflecting layer 28. The light-emitting diode columns 36 extend in straight lines in a direction perpendicular to the first and second power-supply conductors 29 and 30, and are arranged in parallel at intervals.

Each of the light-emitting diode columns 36 includes a plurality of light-emitting diodes 37 and a plurality of first bonding wires 38. The light-emitting diodes 37 are an example of light-emitting elements. Each of the light-emitting diodes 37 is formed of a bare chip which includes a light-emitting layer 37a which emits, for example, blue light. Each light-emitting diode 37 has a rectangular shape in a plan view, the longer sides thereof has a length of, for example, 0.5 mm, and the shorter sides thereof has a length of 0.25 mm. Each light-emitting diode 37 includes a pair of electrodes 37b, which have different polarities, on the light-emitting layer 37a. FIG. 4 illustrates only one of the electrodes 37b in each light-emitting diode 37.

Each light-emitting diode 37 is bonded onto the light-reflecting surface 32 by using a translucent die bond material. In addition, the light-emitting diodes 37 of each light-emitting diode column 36 are arranged at intervals in a line in the direction perpendicular to the first and second power-supply conductors 29 and 30. As a result, as illustrated in FIG. 3, the light-emitting diodes 37 are regularly arranged in rows and columns to spread over a wide range of the light-reflecting surface 32.

In other words, the light-reflecting surface 32 has a sufficient size on which all the light-emitting diodes 37 can be bonded together. Therefore, the light-reflecting surface 32 continues between adjacent light-emitting diodes 37 without a break. As a result, the insulating layer 27 under the light-reflecting surface 32 is not exposed from any space between adjacent light-emitting diodes 37.

Each first bonding wire 38 electrically connects light-emitting diodes 37, which are adjacent in a direction where the light-emitting diode column 36 extends, in series. Specifically, each first bonding wire 38 extends over adjacent light-emitting diodes 37 to connect the electrodes 37b having different polarities of the adjacent light-emitting diodes 37.

One end of each light-emitting diode column 36 is electrically connected to the first power-supply conductor 29 through a second bonding wire 40a. In the same manner, the other end of each light-emitting diode column 36 is electrically connected to the second power-supply conductor 30 through a third bonding wire 40b. Therefore, the light-emitting diode columns 36 are electrically connected to the first and second power-supply conductor 29 and 30 in parallel.

As illustrated in FIG. 3, a pair of power-supply terminals 42a and 42b are arranged on the insulating layer 27 of the module substrate 25. The power-supply terminals 42a and 42b are arranged in a position out of the light-reflecting surface 32. One power-supply terminal 42a is electrically connected to the first power-supply conductor 29 through a conductor pattern (not shown). The other power-supply conductor 42b is electrically connected to the second power-supply conductor 30 through a conductor pattern (not shown).

In addition, a connector 43 is soldered to the power-supply terminals 42a and 42b. The connector 43 is electrically connected to the lighting device 5 through a coated electrical wire 44 illustrated in FIG. 2. The coated electrical wire 44 is guided to the internal space of the base 4, through the through-hole 11 of the lamp body 2 and the through-hole 17 of the base support 15.

As illustrated in FIG. 3 and FIG. 4, a frame member 45 is fixed onto the insulating layer 27. The frame member 45 is formed of an insulating material such as synthetic resin, and encloses the light-reflecting layer 28, and the first and second power-supply conductors 29 and 30 all together. In other words, the light-emitting diodes 37, and the first to third bonding wires 38, 40a, and 40b are contained in a rectangular area enclosed by the frame member 45.

In addition, the frame member 45 is slightly distant from an outer edge of the light-reflecting layer 28, an outer edge of the first power-supply conductor 29, and an outer edge of the second power-supply conductor 30. Therefore, part of the insulating layer 27 is exposed in the area enclosed by the frame member 45.

A sealing material 46 fills the area enclosed by the frame member 45. The sealing material 46 is formed of a translucent resin material such as a transparent silicone resin. The resin material in a liquid state is injected into the area enclosed by the frame member 45. The sealing material 46 injected into the area is heated and dried, and thereby hardened.

As a result, the sealing material 46 is superposed on the insulating layer 27 to cover the light-reflecting layer 28, the first power-supply conductor 29, the second power-supply conductor 30, the light-emitting diodes 37, and the first to third bonding wires 38, 40a, and 40b. Therefore, the sealing material 46 continuously covers the part of the insulating layer 27 which is exposed in the area enclosed by the frame member 45.

In the present embodiment, a fluorescent material is mixed into the sealing material 46. The fluorescent material is uniformly dispersed in the sealing member 46. As the fluorescent material, yellow fluorescent material which is excited by blue light emitted by the light-emitting diodes 37 and emits yellow light is used.

The fluorescent material mixed into the sealing material 46 is not limited to yellow fluorescent material. For example, red fluorescent material which is excited by blue light and emits red light or green fluorescent material which emits green light may be added to the sealing member 46, to improve color rendering properties of the light emitted by the light-emitting diodes 37.

In the LED lamp 1 having the above structure, a voltage is applied to the light-emitting module 6 through the lighting device 5. Consequently, the light-emitting diodes 37 on the light-reflecting layer 28 emit light all together. Blue light emitted by the light-emitting diodes 37 is made incident on the sealing member 46. Part of the blue light which is made incident on the sealing member 46 is absorbed into the yellow fluorescent material. The rest of the blue light does not collide with the yellow fluorescent material, but passes through the sealing material 46.

The yellow fluorescent material which has absorbed the blue light is excited and emits yellow light. The yellow light passes through the sealing material 46. Consequently, the yellow light and the blue light are mixed together inside the sealing material 46, and changed to white light. The white light is radiated from the sealing member 46 toward the translucent cover 3. Therefore, the sealing material 46 which fills the area enclosed by the frame member 45 functions as a surface light-emitting part.

Light which is emitted from the light-emitting diodes 37 toward the module substrate 25 is reflected by the light-reflecting surface 32 of the light-reflecting layer 28, and surfaces of the first and second power-supply conductors 29 and 30, and goes toward the translucent cover 3. Consequently, most of the light emitted from the light-emitting diodes 37 is transmitted through the translucent cover 3 and used for illumination.

Heat of the light-emitting diodes 37, which is produced when the light-emitting diodes 37 emit light, is conducted to the light-reflecting layer 28 which is formed by combining three types of metals. The light-reflecting layer 28 functions as a heat spreader which spreads heat of the light-emitting diodes 37 over a wide range. In addition, the heat of the light-emitting diodes 37, which is spread by the light-reflecting layer 28 is conducted to the metal base 26 through the insulating layer 27, and conducted to the support surface 7 of the lamp body 2 through the base 26. The heat conducted to the lamp body 2 is discharged from the thermally radiative fins 12 to the outside of the LED lamp 1.

Consequently, heat of the light-emitting diodes 37 can be actively released from the module substrate 25 to the lamp body 2. Therefore, it is possible to enhance the heat radiation property of the light-emitting diodes 37, and maintain good luminous efficacy of the light-emitting diodes 37.

According to the light-emitting module 6 having the above structure, part of the insulating layer 27 formed of epoxy resin is exposed in the inside area of the frame member 45 which defines the light-emitting part of the light-emitting module 6, and covered with the sealing member 46. Therefore, it is inevitable that part of light emitted from the light-emitting diodes 37 is made incident on the insulating layer 27, and heat of the light-emitting diodes 37 is conducted to the insulating layer 27 through the light-reflecting layer 28.

When the epoxy resin which forms the insulating layer 27 receives light and heat, the resin component which serves as a framework of the epoxy resin is gradually deteriorated, and produces a gaseous decomposed material. Glycidyl ester-type, linear aliphatic epoxide-type, and alicyclic epoxide-type epoxy resins used in the present embodiment are not exceptions, and their resin components which serve as frameworks thereof are decomposed by light and heat and produce a gaseous decomposed material.

However, gaseous decomposed materials of glycidyl ester-type, linear aliphatic epoxide-type, and alicyclic epoxide-type epoxy resins are more resistant to light and heat than that of glycidyl ether-type and glycidyl amine-type epoxy resins which are mainly used in prior art, and are difficult to deteriorate.

Therefore, even when the gaseous decomposed material adheres to the light-reflecting surface 32, there is low possibility that the decomposed material is carbonized on the light-reflecting surface 32. In addition, even if the decomposed material is carbonized, a quantity of the carbonized material is small. Therefore, blackish stains are not easily formed on the light-reflecting surface 32, and it is possible to maintain good light reflectance of the light-reflecting surface 32.

In particular, in the epoxy resin of the present embodiment, acid anhydride is used as a hardener. According to investigation by the inventor(s), it has been verified that decomposed components of phenol-type resin and amine-type resin which are used as hardeners in epoxy phenol-type epoxy resin and epoxy amine-type epoxy resin cause blackening of the silver light-reflecting surface. In comparison with this, it has been verified that epoxy resin using acid anhydride as a hardener does not cause blackening of the silver light-reflecting surface, even when the acid anhydride is decomposed.

Therefore, in epoxy resin using an acid anhydride-type hardener, there is no reaction between a decomposed component of the hardener and the silver light-reflecting surface 32, or they react with each other with a neglectable quantity. Therefore, from the viewpoint of preventing the light-reflecting surface 32 from blackening, it is desirable to use glycidyl ester-type, linear aliphatic epoxide-type or alicyclic epoxide-type epoxy resin in combination with an acid anhydride-type hardener.

In addition, since the insulating layer 27 is superposed on the metal base 26, heat of the light-emitting diodes 37 is easily conducted from the insulating layer 27 to the base 26. This structure reduces heat influence of the light-emitting diodes 37 on the insulating layer 27, and thus the insulating layer 27 is not easily deteriorated. Therefore, the gaseous decomposed material itself produced by the insulating layer 27 is reduced in quality, which is convenient for suppressing discoloration of the light-reflecting surface 32 due to the decomposed material.

According to the above structure, the LED lamp 1 which includes the light-emitting module 6 can efficiently extract light emitted from the light-emitting module 6 via the translucent cover 3, and maintain an expected light output for a long period.

The inventor(s) performed the following experiment to verify superiority of the light-emitting module 6 which includes the insulating layer 27 formed of glycidyl ester-type, linear aliphatic epoxide-type, or alicyclic epoxide-type epoxy resin.

In the experiment, a light-emitting module which has the structure of the present embodiment, and a light-emitting module which serves as a comparative example and includes an insulating layer using phenol amine-type resin or amine-type resin as a hardener were prepared, and the both light-emitting modules were continuously made emit light (lit) for 1,000 hours.

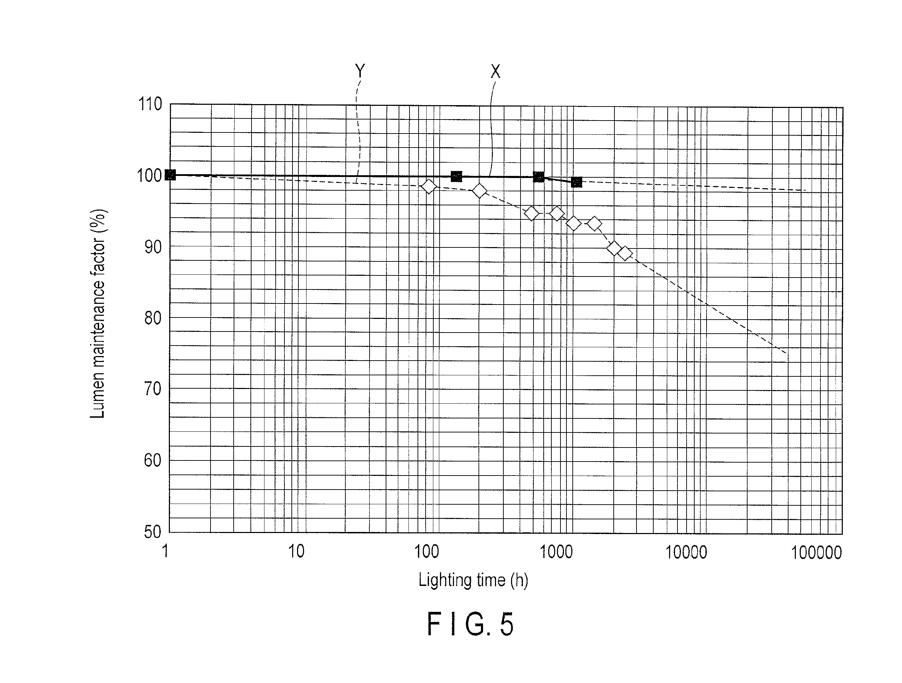

FIG. 5 illustrates lumen maintenance factors obtained when the light-emitting module of the present embodiment and the light-emitting module of the comparative example were continuously made emit light for 1,000 hours. In FIG. 5, X indicates transition of a lumen maintenance factor obtained from the light-emitting module of the present embodiment. Y indicates transition of a lumen maintenance factor obtained from the light-emitting module of the comparative example.

The term "lumen maintenance factor" indicates a ratio of luminous flux at initial light emission when the light-emitting module first emits light to luminous flux at the time when 1,000 hours has passed from the initial light emission. As is clear from FIG. 5, according to the light-emitting module having the structure of the present embodiment, the lumen maintenance factor is secured at 98% or more even when the lighting time reaches 1,000 hours.

In comparison with this, the lumen maintenance factor of the light-emitting module of the comparative example decreases to about 94% when 1,000 hours has passed. This fact shows that the light-emitting module having the structure of the present embodiment improves the lumen maintenance factor by about 4%.

In addition, the life of light-emitting modules is generally set to about 40,000 hours in proper use. Therefore, in view of the tendency of decrease in lumen maintenance factor at the time when 1,000 hours has passed from the initial light emission, there is the fear that the lumen maintenance factor of the light-emitting module of the comparative example at the time when 40,000 hours has passed from the initial light emission is greatly lower than 80%, at which ideal brightness is obtained as ordinary illumination.

In comparison with this, it was found that the luminous maintenance factor of the light-emitting module having the structure of the present embodiment still maintained a high value of 98% or more even at the time when 40,000 hours has passed from the initial light emission.

It is considered that this is because blackening of the light-emitting surface is suppressed in the light-emitting module of the present embodiment, even when a gaseous decomposed material is produced from the insulating layer because of light and heat emitted from the light-emitting diodes. Therefore, it is clear that a light-emitting surface which is prevented from blackening and has fewer stains effectively contributes to prevention of decrease in lumen maintenance factor of the light-emitting module.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module **characterized by** comprising:
a module substrate (25) which includes an insulating layer (27) formed of at least one of a glycidyl ester-type, linear aliphatic epoxide-type, and alicyclic epoxide-type resin;
a light-reflecting layer (28) which is superposed on the insulating layer (27), and includes a sliver light-reflecting surface (32) that has light reflectance higher than that of the insulating layer (27);
a plurality of light-emitting elements (37) which are mounted on the module substrate (25); and
a translucent sealing material (46) which is superposed on the insulating layer (27) to cover the light-reflecting layer (28) and the light-emitting elements (37).

2. The light-emitting module of claim 1, **characterized in that**
the resin is made by using acid anhydride as a hardener.

3. The light-emitting module of claim 1, **characterized in that**
the module substrate (25) includes a metal base (26), the base (26) includes a rough surface (26b) on which the insulating layer (27) is superposed.

4. The light-emitting module of claim 3, **characterized in that**
the light-reflecting layer (28) includes a metal layer (C) which serves as an underlayer of the light-reflecting surface (32), the metal layer (C) includes a rough mating surface (33) which is superposed on the insulating layer (27).

5. An illumination device **characterized by** comprising:
a body (2);
a light-emitting module (6) which is supported by the body (2); and
a lighting device (5) which is provided in the body (2) and lights the light-emitting module (6),
wherein the light-emitting module (6) includes:
a module substrate (25) which includes an insulating layer (27) formed of at least one of a glycidyl ester-type, linear aliphatic epoxide-type, and alicyclic epoxide-type resin;
a light-reflecting layer (28) which is superposed on the insulating layer (27), and includes a sliver light-reflecting surface (32) that has light reflectance higher than that of the insulating layer (27);
a plurality of light-emitting elements (37) which are mounted on the module substrate (25); and
a translucent sealing material (46) which is superposed on the insulating layer (27) to cover the light-reflecting layer (28) and the light-emitting elements (37).

6. The illumination device of claim 5, **characterized in that**
the module substrate (25) includes a metal base (26) on which the insulating layer (27) is superposed, and the body (2) is formed of metal and includes a support surface (7) on which the base (26) is fixed.

7. The illumination device of claim 6, **characterized in that**
the module substrate (25) is thermally connected to the body (2).
